(19) **Europäisches Patentamt / European Patent Office / Office européen des brevets**

(11) **EP 2 862 031 B1**

(12) # EUROPEAN PATENT SPECIFICATION

(45) Date of publication and mention of the grant of the patent:
**05.06.2019 Bulletin 2019/23**

(51) Int Cl.:
***G05B 23/02*** *(2006.01)*    ***G06F 17/10*** *(2006.01)*
***G06F 17/50*** *(2006.01)*

(21) Application number: **12879190.2**

(22) Date of filing: **19.06.2012**

(86) International application number:
**PCT/SE2012/000096**

(87) International publication number:
**WO 2013/191596 (27.12.2013 Gazette 2013/52)**

(54) **METHOD FOR GENERATING A SIMPLIFIED CALCULATION MODEL AND METHOD FOR PREDICTING LIFE CONSUMPTION OF A COMPONENT**

VERFAHREN ZUR ERZEUGUNG EINES VEREINFACHTEN RECHENMODELLS UND VERFAHREN ZUR VORHERSAGE DES LEBENSDAUERVERBRAUCHS EINES BAUTEILS

PROCÉDÉ DE GÉNÉRATION D'UN MODÈLE DE CALCUL SIMPLIFIÉ ET PROCÉDÉ DE PRÉDICTION DE L'UTILISATION DE LA DURÉE DE VIE D'UN COMPOSANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**22.04.2015 Bulletin 2015/17**

(73) Proprietor: **GKN Aerospace Sweden AB**
**461 81 Trollhättan (SE)**

(72) Inventors:
• **PERSSON, Roger**
 **561 54 Trollhättan (SE)**
• **HENRIKSSON, Mattias**
 **413 18 Göteborg (SE)**

(74) Representative: **D Young & Co LLP**
**120 Holborn**
**London EC1N 2DY (GB)**

(56) References cited:
EP-A1- 2 390 742    EP-A2- 2 045 673
US-A1- 2007 198 215    US-A1- 2007 198 215
US-A1- 2008 040 152    US-A1- 2011 137 575
US-A1- 2011 137 575

• **PFOERTNER H: "The information content of turbine engine data - a chance for recording-based life usage monitoring", AEROSPACE CONFERENCE PROCEEDINGS, 2002. IEEE MAR 9-16, 2002, PISCATAWAY, NJ, USA,IEEE, vol. 6, 9 March 2002 (2002-03-09), pages 2975-2985, XP010604866, ISBN: 978-0-7803-7231-3**
• **THEILLIOL D ET AL: "A hierarchical fault diagnosis method using a decision support system applied to a chemical plant", SYSTEMS, MAN AND CYBERNETICS, 1995. INTELLIGENT SYSTEMS FOR THE 21ST C ENTURY., IEEE INTERNATIONAL CONFERENCE ON VANCOUVER, BC, CANADA 22-25 OCT. 1995, NEW YORK, NY, USA,IEEE, US, vol. 3, 22 October 1995 (1995-10-22), pages 2205-2210, XP010194656, DOI: 10.1109/ICSMC.1995.538108 ISBN: 978-0-7803-2559-3**
• **PFOERTNER, H.: 'The information content of turbine engine data - a chance for recording-based life usage monitoring' AEROSPACE CONFERENCE PROCEEDINGS, 2002 vol. 6, 09 March 2002 - 16 March 2002, PISCATAWAY, NJ, USA, pages 2975 - 2985, XP010604866**
• **LYYER ET AL.: 'Aircraft life management using crack initiation and crack growth models - P-3C Aircraft experience' INTERNATIONAL JOURNAL OF FATIGUE vol. 29, no. 9-11, 2007, pages 1584 - 1607, XP022209240**

EP 2 862 031 B1

**(Cont. next page)**

• PAPAZIAN J M ET AL.: 'SIPS, A Structural Integrity Prognosis System' AEROSPACE CONFERENCE 2007, PISCATAWAY, NJ, USA, pages 1 - 10, XP025996245

## Description

<u>Field of the Disclosure</u>

The present disclosure relates to the field of calculation of life consumption of components, and more specifically to a method for generating a simplified calculation model based on load data from a load session and on actual stresses, strains, temperatures and life consumption calculated by means of a numerical calculation model. The present disclosure also relates to prediction of life consumption for a component using a simplified calculation model and especially the generated simplified calculation model. Moreover, the present disclosure further relates to a system and computer program product for generating the simplified calculation model and for predicting life consumption of components.

<u>Background of the Disclosure</u>

Today, there is significant interest in developing methods and systems for improving the prediction of the life consumption of individual components in a machine, in particular machines with moving parts. By improving the accuracy of such methods, the applied safety limits may be reduced, and unnecessary replacement of components may be avoided. When applied to an entire fleet (e.g. a military aircraft fleet) the cost savings may be significant as well as allowing for an increased operational lifetime. Furthermore, in the unusual event that conventional methods are too optimistic, refined methods may avoid failure of components, thus avoiding uncalculated stops in operation or even more importantly accidents.

Examples of interesting applications where improved life consumption predictions may be useful include aircrafts, gas/steam turbines, trucks, loaders, nuclear plants and wind turbines.

A conventional method for predicting the life consumption of a component in a machine is to measure one or a combination of the usage/run time, distance or count the number of cycles of a predefined load session or a conservative load session. A load session is the time when the machine is in operation, for example for an aircraft a load session may be defined as flying from point A to point B with a predefined rotor speed variation. Prediction of the estimated life consumption of the component may thereafter be calculated by using a numerical calculation method, such as e.g. the finite element method, FEM. The FEM-method calculates stresses and strains for the component exposed to various loads during the load session, such as e.g. thermal and mechanical loads. The FEM-method calculates stresses and strains by using a mesh pattern on e.g. a 2D-model or a 3D-model, wherein the mesh pattern comprises nodes and elements. By utilizing a denser mesh, i.e. smaller elements per area resulting in a larger number of nodes and elements, the accuracy of the results are improved.

Although the FEM-method provides for a substantially accurate method for determining the stresses and strains of a component exposed to a load session, the method is very time consuming in terms of required CPU-time. In particular, the required CPU-time increases significantly for components having e.g. a complicated geometry, contact surfaces to other components, or where there is a need of providing a denser mesh for achieving reliable results.

Hence, there is a need for an improved calculation method which is less time consuming while still providing reliable results.

US 2011/137575 A1 discloses a method and system for real-time prognosis analysis and usage based residual life assessment of turbine engine components and display.

PFOERTNER H, The information content of turbine engine data - a chance for recording based life usage monitoring. USA: IEEE vol. 6, pages 2975-2985, 9 March 2002.

EP 2 045 673 A2 discloses a method and apparatus for intelligent control and monitoring in a process control system.

<u>Summary of the Disclosure</u>

Particular aspects of the invention are set out in the appended claims.

In view of the above-mentioned drawbacks of the prior art, it is an object of the present disclosure to provide a method for generating a simplified calculation model for use in predicting life consumption of a component which is less time consuming in relation to finite element models, FE-models, while still being able to provide reliable results. It is also an object of the present disclosure to provide a method for predicting life consumption of components.

The present disclosure is based on the insight that calculation of e.g. stresses, strains, temperatures and predicted life consumption for a component exposed to a set of loads can be accomplished by means of a simplified calculation model instead of using a complex and time consuming FE-model. By generating a simplified calculation model using already known results from a numerical method model exposed to a load session resulting from a set of load input data, the simplified calculation model can thereafter be used for other sets of load input data for calculating stresses, strains and temperatures exposed to the component. Hereby, a less time consuming calculation model is provided which is able to provide reliable results in terms of e.g. stresses, strains, temperatures and predicted life consumption for the component.

According to a first teaching of the present disclosure there is provided a method for generating a simplified calculation model for use in predicting life consumption of a component subjected to loads during operation, comprising the steps of: receiving a first set of load input data resulting from a first set of load sessions during operation; calculating at least one of stresses, strains and temperatures for a critical area of the component by means of a numerical calculation model; predicting life consumption of the component based on the at least one of the numerically calculated stresses, strains and temperatures; and generating the simplified calculation model defining a relationship between load input data and predicted life consumption by means of: assigning a plurality of linear difference equations for the simplified calculation model; and calculating parameters of the plurality of linear difference equations based on the relationship between the first set of load input data and the numerically calculated predicted life consumption.

The wording "numerical calculation" should in the following and throughout the entire description be interpreted as a calculation method using explicit or implicit iterative calculations in order to achieve a desired result. The numerical method may use a mesh or a grid provided to e.g. 2D- or 3D CAD models, which calculates e.g. stresses, strains and temperatures for each node and/or element provided by the mesh/grid. The numerical calculation method may, for example, use the finite element method, FEM, to calculate stresses and/or strains, which will be described further below.

Moreover, the "critical area of a component" should be understood to mean a position of a component in e.g. an engine which is likely to be affected, or has been identified by other means to be relatively highly affected, by loads during operation. A position of the component may, for example, be regarded as a critical area if it is positioned in proximity to a high-temperature element of the engine or if it e.g. comprises a curved-shaped form having a relatively small radius in which stress concentrations are likely to occur. The list of the types of critical areas can hence be extensive and the specific area of interest must therefore be evaluated for the specific component of interest. Details of how to select critical areas of a component is disclosed in a co-pending application entitled "RELIABLE PREDICTION OF LIFE CONSUMPTION OF A MACHINE COMPONENT".

The critical area of the component may hence be regarded as a limiting factor when evaluating predicted life consumption of the total engine component.

Furthermore, the simplified calculation model should in the following be interpreted as a calculation model which comprises a set of linear difference equations that is built up by use of known input and known output, i.e. input and output received from the above mentioned numerical calculation model. The simplified calculation model hence comprises a plurality of parameters which are calculated by means of linear difference equations such that a relation between the inputs, i.e. the loads, and the outputs, i.e. the stresses, strains, temperatures and/or the predicted life consumption corresponds to the corresponding inputs and outputs of the numerical calculation model. In more detail, the parameters are configured to linearly describe the relation between the inputs and the outputs of the simplified calculation model so that its predicted life consumption more or less resembles the predicted life consumption calculated by means of the numerically calculated component.

Still further, the set of load input data described may be provided by means of, for example, acquiring data from an engine of a machine, such as a car, truck, aircraft, boat, etc. which has been exposed to a set of load sessions, such as driving/flying/moving from point A to point B, thereby being exposed to various loads depending on a number of parameters, such as e.g. driving conditions, weather conditions, driver characteristics, etc. Accordingly, the set of load input data may hence be provided from a plurality of load sessions, i.e. it is not restricted from being provided from only one load session. However, the set of load input data may also be provided by means of experience, i.e. that certain machines are more or less always exposed to a certain type of loads for a specific driving scenario.

Moreover, the expression "first" described above is not intended to limit the scope of the present disclosure. The "first set of load input data" and "first set of load sessions" are not limited to first in terms of consecutive order, but may, for example, be a set of load input data for e.g. a third load session of the structure. Accordingly, the term "first" is merely used to more easily describe the method steps of the disclosure, which will be clearer below when describing teachings of the present disclosure.

An advantage of the present disclosure is, at least, that simplified calculation models may be provided for various components of a structure, which simplified calculation models are able to provide e.g. stress, strain and/or temperature results for components exposed to various sets of loads at an increased speed in comparison to prior art solutions using e.g. FE-models. As the simplified calculation model is generated by means of using input data and corresponding results from a numerical calculation model, which is assumed to calculate and provide correct results for the component, a substantially robust and confident model may be provided.

The simplified calculation model may be in particular advantageous to use for complex components having a number of critical positions which are of interest in acquiring stress-, strain- and/or temperature results, since such a component in e.g. an FE-analysis may require a large number of nodes and elements in order to achieve correct and reliable results, resulting in a very time consuming analysis. By generating a simplified calculation model in accordance with the present disclosure, the FE-analyses may only have to be executed the specific number of times it takes until the simplified calculation model is considered reliable and sufficiently validated. Thereafter, new set of load input data may be provided to the simplified calculation model for calculating stresses, strains and/or temperatures for the component, thereby reducing the time consumption for doing mechanical and thermal analysis.

Moreover, the method may further comprise the steps of: receiving a second set of load input data resulting from a second set of load sessions during operation; calculating at least one of stresses, strains and temperatures for the critical area of the component by means of the numerical calculation model; predicting life consumption of the component based on the at least one of the numerically calculated stresses, strains and temperatures; calculating at least one of stresses, strains and temperatures for the critical area of the component by means of the simplified calculation model; predicting life consumption of the component based on the at least one of stresses, strains and temperatures calculated by means of the simplified calculation model; and verifying that the simplified calculation model is correct if a difference between the numerically calculated predicted life consumption and the predicted life consumption predicted by means of the simplified calculation model is within a predetermined life consumption limit.

Hereby, a verification of the simplified calculation model may be provided so that the predicted life consumption calculated by means of the simplified calculation model is within a predetermined limit in comparison to the predicted life consumption calculated by means of the numerical calculation model. Depending on the desired accuracy of the results, the method may have to be executed for a plurality of times until the difference is within an acceptable limit range. Accordingly, the predetermined life consumption limit can be different for different applications. For example, if verification is made for a component in a truck, an accepted difference in predicted life consumption may be higher compared to a component in e.g. an aircraft.

If the predicted life consumption differ more than the acceptable predefined limit range, the parameters of the simplified calculation model may be adjusted by re-calculation and iteration of the parameters and thereafter compare predicted life consumptions for the two models again. Moreover, when the simplified calculation model is considered correct and subsequent analysis are performed for that model, a random validation of the model may be executed on a more or less regular basis in order to further validate the correctness of the model, which will be further described below.

Moreover, the wording "second" should not be construed as limiting the scope of the present disclosure, for the same reasons as described above in relation to the wording "first". Also, the second set of load input data may also not necessarily have to be a subsequent set of load input data following the first set of load input data; it should hence rather be interpreted as a load input data which is different from the first load input data.

According to an example teaching of the present disclosure, the step of predicting life consumption of the component based on the at least one of stresses, strains and temperatures calculated by means of the simplified calculation model may be preceded by the steps of: comparing the numerically calculated stresses and/or strains with the stresses and/or strains calculated by means of the simplified calculation model; and predicting life consumption of the component based on the at least one of stresses, strains and temperatures calculated by means of the simplified calculation model if a difference in stresses and/or strains is within a predetermined stress and/or strain limit.

Hereby, the stresses and/or strains calculated by means of the numerical calculation model and the simplified calculation model may be compared to each other in order to provide an initial indication that the simplified calculation model is correct or not. The stress and/or strain limit may hence provide a measure of the likelihood that the simplified calculation model will provide reliable results in terms of life consumption. An advantage is that a further parameter is provided for verification of the simplified calculation model. Furthermore, the predetermined stress and/or strain limit may vary depending on the desired accuracy of the results as described above in relation to the predetermined life consumption limit.

Furthermore, the step of predicting life consumption of the component based on the at least one of stresses, strains and temperatures calculated by means of the simplified calculation model may be preceded by the steps of: comparing the numerically calculated temperatures with the temperatures calculated by means of the simplified calculation model; and predicting life consumption of the component based on the at least one of stresses, strains and temperatures calculated by means of the simplified calculation model if a difference in temperatures is within a predetermined temperature limit.

An advantage is that a still further comparison of the numerical model and the simplified calculation model may be provided for indication of the correctness of the simplified calculation model. The comparison of temperatures may be provided in combination with the comparison of stresses and/or strains, or the different comparisons may be executed independently of each other. Similar to the above description, the predetermined temperature limit may vary depending on the desired accuracy of the simplified calculation model.

Still further, the simplified calculation model may be generated by means of iteratively calculating the parameters of the linear difference equations until the verification that the simplified calculation model is within the predetermined life consumption limit.

According to an example teaching of the present disclosure, the linear difference equations may comprise the equation:

$$y_i(t) + a_i\_1 \times y_i(t-1) + \ldots + a_i\_na \times y_i(t-na) = b_i\_1 \times u_i(t-nk) + \ldots + b_i\_nb \times u_i(t-nk-nb+1)$$

wherein ui(t) are time-dependent inputs resulting from the load sessions during operation, yi(t) are time-dependent stresses, strains or temperatures, na and nb are the number of ai- and bi-parameters, respectively, and nk are the number of sample times before the current time t.

The equation described may hence provide a relation between the inputs, i.e. the loads, and the outputs, i.e. at least one of stresses, strains and temperatures, by means of the parameters.

Moreover, the linear difference equations may further comprise equations relating the stresses, strains and temperatures with the predicted life consumption.

Hereby, when the parameters of the simplified calculation model have been calculated, the stresses, strains and temperatures, i.e. the outputs from the above equation, are related to the predicted life consumption. This relation may be realized by means of a Wöhler diagram or the like which will be described further below.

According to an example teaching of the present disclosure, the simplified calculation model may be a linear ARX model having a plurality of parameters, wherein said parameters are estimated by means of said load input data and at least one of said calculated stresses, strains, temperatures and life consumption.

A linear ARX model is well known and comprises a plurality of parameters which may be iteratively calculated such that the parametric model corresponds to the real physical 2D- or 3D model, wherein the parameters are calculated by means of the above method steps for generating the parametric calculation model. Accordingly, the linear ARX model is a linear difference equation calculating the parameters based on given input and given output. However, the disclosure should not be limited to a simplified calculation model using linear ARX, other so called "black box" algorithms are also conceivable, which uses known input and output to generate parameters for achieving the simplified calculation model.

Moreover, the simplified calculation model may comprise a temperature calculating module and a stress/strain calculating module. Hereby, separate modules are provided for calculating temperatures and stresses/strains of the component. Accordingly, when controlling the simplified calculation model, generation of parameters can be made separately for the temperature module and stress/strain module, thereby having a less number of parameters for each module compared to a single module calculating both temperatures and stresses/strains.

Still further, the calculated stresses, strains and temperatures may be time-dependent components. By calculating stresses, strains and temperatures as a function of time, the load history of the components are being taken into account, thereby calculating loads corresponding to an actual scenario of the component during a load session, which load session hence comprises a plurality of time-dependent loads.

According to an example teaching, the load sessions may be constituted by recorded loads from a flight mission of an aircraft.

Hereby, when an aircraft has been exposed to a flight mission, the engine of the aircraft is connected to a computer or the like which receives information relating to the specific flight and hence to the time dependent loads exerted to the engine during the flight mission. Accordingly, depending on different flight conditions during the specific mission such as e.g. weather, pilot behavior, etc. loads affecting the engine due to these conditions are provided from the engine in order to be able to calculate predicted life consumption for components during that specific mission.

Furthermore, the numerical calculation model may be a mesh-based numerical model using finite element calculations. As described above, finite element calculations may provide substantially accurate and reliable stress, strain and temperature results for a component exposed to a load session. As also described above, using a denser mesh, i.e. more nodes and elements per area, an improved accuracy of the results may be provided. Accordingly, by using finite element calculations for generating, verifying and validating the simplified calculation model, the model is generated for substantially accurate stresses, strains and temperatures corresponding to the true behavior of the component.

Still further, the load input data may comprise at least one of thermal- and mechanical loads. These types of loads are typically affecting a component during, for example, a flying session of an aircraft given as an example above. The mechanical loads may comprise velocity loads, gravitational loads, inertia loads, pressure loads, etc. The thermal loads may on the other hand comprise temperature differences during the load session, heat flux, friction, heat transfers, etc. The loads may also, as described above, be provided as a function of time, i.e. the load history of the mechanical and thermal loads may be included in the load input data.

According to a second teaching of the present disclosure, there is provided a method for predicting life consumption of a component subjected to loads during operation, comprising the steps of: receiving a first set of load input data resulting from a first load session during operation; calculating at least one of stresses, strains and temperature for a critical area of the component based on the first set of load input data by means of a simplified calculation model comprising linear difference equations; and predicting life consumption of the component for the first load session based on the at least one of the calculated stresses, strains and temperatures.

Hereby, a relatively rapid prediction of the life consumption for the component may be provided for the first load session, for example, an aircraft flying from point A to point B. Instead of using the above described prior art solutions; the simplified calculation model provides stresses, strains and temperatures of the component during the load session in a less time consuming manner compared to e.g. a finite element analysis model. Thereafter, a prediction of the life consumption for the load session may be provided. In more detail, a ratio of the consumption of the total life time of the component may be predicted.

Furthermore, the simplified calculation model may be generated according to the above described first teaching of the present disclosure.

Moreover, the method may further comprise the steps of: receiving a second set of load input data resulting from a second load session during operation; calculating at least one of stresses, strains and temperatures for the critical area of the component by means of the simplified calculation model; predicting life consumption of the component for the second load session based on the calculated stresses, strains and temperatures; and adding the predicted life consumption resulting from the second load session with the predicted life consumption resulting from the first load session for accumulation of life consumption of the component.

Hereby, when the component has been exposed to another load session, for example, a flight from point B to point C, the predicted life consumption of the component when exposed to the flight from point B to point C may be added to the predicted life consumption of the component when exposed to the flight from point A to point B. Accordingly, an accumulation of the predicted life consumption for the component can be provided in order to continuously determine a remaining life time of the specific component. The terms "first load session" and "second load session" should hence, as also described above, not limit the scope of the present disclosure to include only two load sessions. The method naturally calculates and adds predicted life consumption continuously for new load sessions, such as e.g. new flights, until the component is in need of replacement. Thereafter, when the component has reached its total lifetime, it may be replaced by a new component and the steps of the method may be re-started.

Furthermore, the life consumption may be predicted by means of calculating principal stresses and/or strains exposed to the structure in combination with temperature loads. Calculation of principal stresses and/or strains can, by use of e.g. a Wöhler diagram or the like, be used to determine the amount of life consumption being utilized by the component. When, as described above, adding predicted life consumption for a first load session with the predicted life consumption of a second load session, it may be essential to compare and add principal stresses having the same principal directions, i.e. the principal stress/strain component should hence be projected to correspond to the direction of corresponding principal stress/strain directions for other load sessions. Moreover, the method may be used for determining and detecting crack initiation of a component, since cracks are one important teaching when determining life consumption.

According to a teaching, the method may be further preceded by the steps of: receiving a third set of load input data resulting from a third load session during operation; calculating at least one of stresses, strains and temperatures for the critical area of the component by means of the numerical calculation model and the simplified calculation model; predicting life consumption of the component for the third load session based on the at least one of stresses, strains and temperatures calculated by means of the numerical calculation model and the simplified calculation model; and validating that the simplified calculation model is correct if a difference between the numerically predicted life consumption and the predicted life consumption predicted by means of the simplified calculation model is within a predetermined life consumption limit.

An advantage is that a reliable model may be provided. The validation of the model may be executed on a regular basis.

Other teachings, features and advantages with this second teaching are largely analogous to those described above in relation to the first teachingof the present disclosure.

According to a third teaching of the present disclosure, there is provided a system for generating a simplified calculation model, wherein the system comprises: a load session module comprising load session information exposed to a machine during operation; a load input data module comprising load generating means for transformation of load session information to thermal and mechanical loads; a numerical calculation model comprising a temperature calculating module and a stress/strain calculating module; a simplified calculating module comprising a temperature calculating module and a stress/strain calculating module; and a life consumption prediction module comprising means for predicting life consumption based on at least one of stresses, strains and temperatures; wherein said system is configured to: receive a first set of load input data resulting from a first set of load sessions during operation; calculate at least one of stresses, strains and temperatures for a critical area of a component by means of the numerical calculation model; predict life consumption of the component based on the at least one of the numerically calculated stresses, strains and temperatures by means of the life consumption prediction module; and generate the simplified calculation model defining a relationship between load input data and predicted life consumption for the component by means of: assigning a plurality of linear difference equations for the simplified calculation model; and calculating parameters of the plurality of linear difference equations based on the relationship between the first set of load input data and at least one of the numerically calculated predicted life consumption.

According to a fourth teaching of the present disclosure there is provided a system for predicting life consumption of a component subjected to loads during operation, wherein the system comprises: a load session module comprising load session information exposed to a machine during operation; a load input data module comprising load generating means for transformation of load session information to thermal and mechanical loads; a simplified calculation model comprising a temperature calculating module and a stress/strain calculating module; and a life consumption prediction module comprising means for predicting life consumption based on at least one of stresses, strains and temperatures; wherein said system is configured to: receive a first set of load input data resulting from a first load session during operation; calculate at least one of stresses, strains and temperature for a critical area of a component based on the first load input data and by means of the simplified calculation model comprising linear difference equations; and predict life consumption of the component for the first load session based on the at least one of the calculated stresses, strains and temperatures.

According to a teaching, the simplified calculation model is generated according to the above description in relation to the third teaching of the present invention.

According to a fifth teaching of the present disclosure there is provided a computer program product comprising a computer readable medium having stored thereon computer program means for causing a processing unit to generate a simplified calculation model of a component subjected to loads during operation, wherein the computer program product comprises: code for executing the method according to the above description in relation to the first teaching of the present disclosure.

According to a sixth teaching of the present disclosure there is provided a computer program product comprising a computer readable medium having stored thereon computer program means for causing a processing unit to predict life consumption of a component subjected to loads during operation, wherein the computer program product comprises: code for executing the method according to the above description in relation to the second teaching of the present disclosure.

The processing unit may preferably be provided in a server or similarly, and the computer readable medium may be one of a removable nonvolatile random access memory, a hard disk drive, a floppy disk, a CD-ROM, a DVD-ROM, a USB memory, an SD memory card, or a similar computer readable medium known in the art.

Features of the third, fourth, fifth and sixth teachings of the disclosure provide similar advantages as discussed above in relation to the previous first and second teachings of the disclosure.

Further features of, and advantages with, the present disclosure will become apparent when studying the appended claims and the following description. The skilled addressee realize that different features of the present disclosure may be combined to create teachings other than those described in the following, without departing from the scope of the present disclosure.

Brief Description of the Drawings

The above, as well as additional objects, features and advantages of the present invention, will be better understood through the following illustrative and non-limiting detailed description of an exemplary embodiment of the present invention, wherein:

Fig. 1 is a flow chart schematically illustrating a method for generating a simplified calculation model according to an embodiment of the present invention;
Fig. 2 is a block diagram schematically illustrating an embodiment of a flow chart for generating a simplified calculation model; and
Fig. 3 is a flow chart schematically illustrating a method for predicting life consumption of components.

Detailed Description of Exemplary Embodiments of the Invention

The present invention will now be described more fully hereinafter with reference to the accompanying drawings, in which an exemplary embodiment of the invention is shown. This invention may, however, be embodied in many different forms and should not be construed as limited to the embodiment set forth herein; rather, this embodiment is provided for thoroughness and completeness. Like reference character refer to like elements throughout the description.

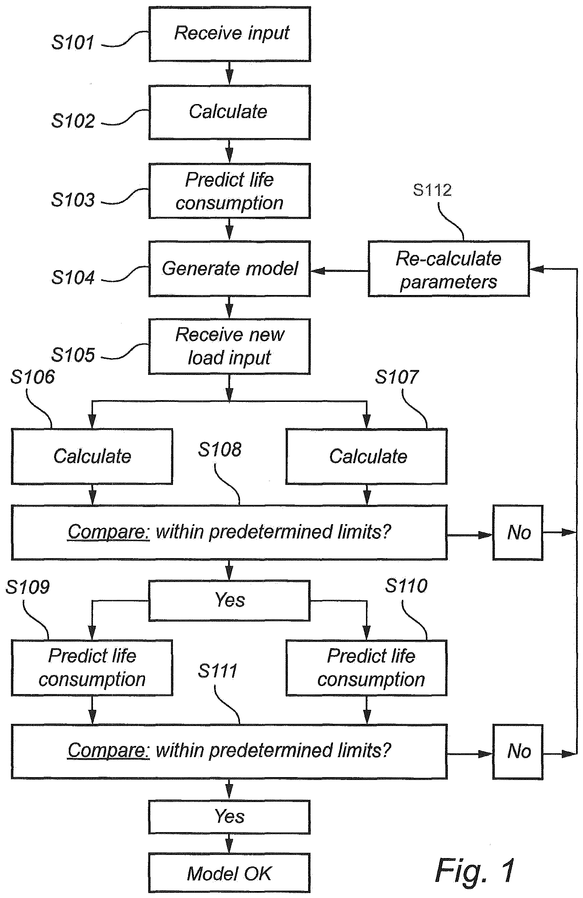

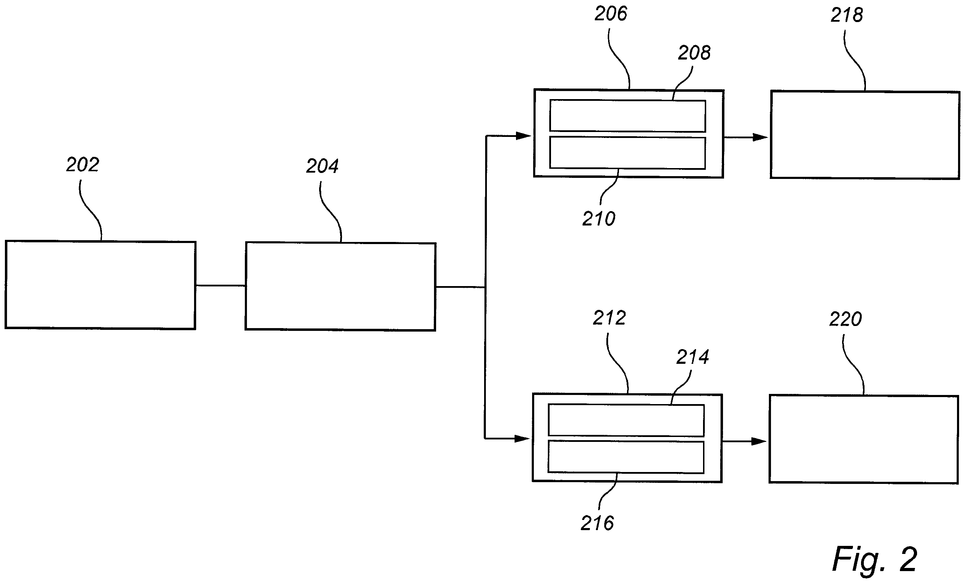

Reference is now made to the drawings and to Figs. 1 and 2 in particular, that schematically illustrates a flow chart of an embodiment of a method for generating a simplified calculation model and a block diagram comprising the components for generating the simplified calculation model.

When generating the simplified calculation model 212 which is depicted in Fig. 2, load input is received S101 from a load session 202 in order to generate load input data 204. The load session 202 may, for example, be a flight session for an engine of an aircraft flying from point A to point B. Other types of load sessions are of course conceivable, such as a car or a truck driving from one point to another. The following description will, however, for simplicity of understanding only relate to an aircraft. The load session 202 can comprise a plurality of time-dependent parameters which has affected the aircraft during the flight from e.g. point A to point B. The parameters provided to the load input data 204 from the load session 202 may hence be different depending on, for example, weather conditions during the flight, pilot behavior, etc and as the parameters are time-dependent, the loads affecting the engine will be continuously registered for the flight from point A to point B. Accordingly, the load session 202 provides time-dependent load data into the load input data 204 which generates, according to the loads affecting the engine during the flight, mechanical and thermal loads.

The mechanical and thermal loads generated at the load input data 204 are thereafter provided to a numerical calculation model 206. More specifically, the thermal loads are provided as input to a temperature module 210 of the numerical calculation model 206 and the mechanical loads are provided as input to a stress/strain module 208 of the numerical calculation module 206. The thermal 210 and stress/strain 208 module may, as an example, use a mesh-based calculation method, such as the Finite Element Method, FEM. Moreover, the thermal module 210 and the stress/strain module 208 thereafter calculates S102 time-dependent stresses, strains and temperatures exposed to a component of the aircraft engine during the load session. The calculated stresses, strains and temperatures of the component are thereafter provided to a life consumption prediction module 218 for predicting S103 the life consumption of the component during the load session 202. Accordingly, the life consumption prediction module 218 predicts how much of the components entire life that has been utilized during the load session. Therefore, a preferred aspect of the invention is to take into account the internal load cycles which the component has been exposed to during the flight, and not only to check the stresses, strains and temperatures when the aircraft has landed.

Now, in order to generate S104 a simplified calculation model 212, the same load input data 204 provided to the numerical calculation model 206 is provided into the simplified calculation model 212. Also, the predicted life consumption generated in the life consumption prediction module 218 is provided to the simplified calculation module 212. Hereby, time-dependent inputs and time-dependent outputs are provided to the simplified calculation module 212 which enables calculation of the parameters of the simplified calculation model 212 by means of linear difference equations relating the time-dependent inputs to the time dependent outputs. As an example, the time-dependent inputs and the time-dependent outputs may be related according to the linear difference equation:

$$y_i(t) + a_{i\_}1 \times y_i(t-1) + ... + a_{i\_}na \times y_i(t-na) = b_{i\_}1 \times u_i(t-nk) + ... + b_{i\_}nb \times u_i(t-nk-nb+1)$$

where:

$u_i(t)$ are the time-dependent inputs resulting from the load sessions during operation,
$y_i(t)$ are the time-dependent outputs, i.e. time-dependent stresses, strains or temperatures,
na and nb are the number of $a_i$- and $b_i$-parameters, respectively,
nk are the number of sample time before the current time t.

Hereby, the various parameters, i.e. a and b may be calculated in order to generate the simplified calculation model 212. Moreover, the linear difference equation further comprises equations relating the outputs, i.e. $y_i(t)$ with the predicted life consumption. In more detail, the simplified calculation module 212 also comprises a stress/strain module 214 and a temperature module 216. Accordingly, the thermal load input is configured to generate parameters of the thermal module 216 and the mechanical load input is configured to generate parameters of the stress/strain module 214. Hence, the above equation example may thus be arranged for the stress/strain module 214 and the thermal module 216, respectively.

In order to verify that the simplified calculation model 212 is correct, i.e. that life consumption prediction made by the simplified calculation model corresponds to corresponding life consumption prediction provided by means of the numerical calculation model, new load input data is received S105 for a new load session 202, both to the numerical calculation model 206 as well as to the simplified calculation model 212. Thereafter, the numerical calculation model 206 calculates S106 stresses, strains and temperatures exposed to the component during the new load session. Moreover, the simplified calculation model 212 also calculates S107 corresponding stresses, strains and temperatures for the simplified calculation model. As an intermediate step of verifying that the simplified calculation model 212 is correct is to compare S108 if the results in terms of stresses, strains and/or temperatures are within predetermined stress/strain-limits as well as within predetermined temperature limits between the numerical calculation model 206 and the simplified calculation model 212. If a difference in stresses and strains between the models is above the predetermined stress/strain limit and if a difference in temperatures between the two models is above the predetermined temperature limit, the parameters of the simplified calculation model 206 are re-calculated S112 by iteratively updating the parameters. The re-calculation S112 may be executed by providing a new load session 202 for receiving S101 a new load input and execute the method steps S101 - S104 as described above. The re-calculation S112 may also be executed by iteratively modifying the parameters of the simplified calculation model 212 using the previously load input data and corresponding life consumption prediction made by the numerical calculation model 206 and to update the parameters. It should, however, be realized that the present invention is not limited to utilizing the step of comparing S108 stresses, strains and temperatures. In such a case the numerical calculation model 206 and the simplified calculation model 212 calculates S106, S107 stresses, strains and temperatures and provide the results to the life consumption prediction module 218, 220, whereby a comparison of the predicted life consumptions is made, which will be further described below.

Moreover, if the stresses, strains and temperatures are within the predetermined limits, the results from the numerical calculation model 206 as well as from the simplified calculation model 212 are each provided to their corresponding life consumption prediction modules 218, 220, respectively, in order to predict S109, S110 corresponding life prediction of the numerical calculation model 206 as well as the simplified calculation model 212. The simplified calculation model 212 is thereafter verified S111 by comparing the predicted life consumption generated by means of the simplified calculation model 212 with the predicted life consumption generated by means of the numerical calculation model 206. If a difference in predicted life consumption between the two models is within a predetermined life consumption limit, i.e. within a certain percentage individually determined by the importance of correctness of the results, the simplified calculation model 212 is considered to be verified and correct. If, however, the difference is above the predetermined limit, the parameters of the simplified calculation model 212 are iteratively re-calculated S112 as described above.

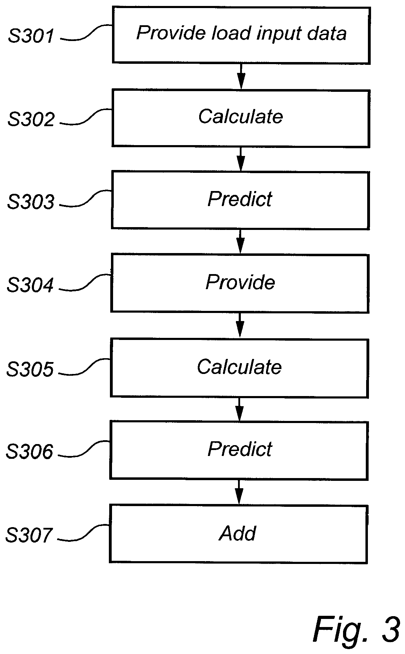

Now, when a simplified calculation model 212 is generated as described above, attention is drawn to Fig. 3 in combination with parts of Fig. 2, wherein Fig. 3 illustrates a flow chart of the method for predicting life consumption of components. It should be noted, that the simplified calculation model 212 generated as described above is only valid for one critical point/area for one component of the aircraft engine. Accordingly, in order to evaluate a plurality of critical points/areas in the aircraft engine, a plurality of simplified calculation models 212 have to be generated.

When the aircraft has made a new, first load session, data is provided from the aircraft engine such that the load input data module 204 can provide S301 load input data in terms of time-dependent mechanical loads and thermal loads, as described above, to the corresponding stress/strain module 214 and the thermal module 216 of the simplified calculation model 212. The simplified calculation model 212 thereafter calculates S302 time-dependent stresses, strains and temperatures which has affected the critical point of the component during the flight received from the load session module 202. The time-dependent stresses, strains and temperatures are provided from the respective modules 214, 216 of the simplified calculation model 212 to the life consumption prediction module 220 for predicting S303 the life consumption occurred during the specific flight. The predicted life consumption of the component for the first flight is thereafter stored. The predicted life consumption may hence be a percentage number of the total life of the component, such as e.g. that the first flight affected the life consumption of the component by 0.2% of its total life.

When the aircraft thereafter has been exposed to a new, second load session 202, i.e. after the aircraft has flown from e.g. a position B to a position C, new data is, similar the above description, provided to the load input data module 204 for providing S304 load input data in terms of time-dependent mechanical loads and thermal loads to the corresponding stress/strain module 214 and the thermal module 216 of the simplified calculation model 212. The simplified calculation model 212 thereafter calculates S305 time-dependent stresses, strains and temperatures which has affected the component during the second flight received from the load session module 202. The time-dependent stresses, strains and temperatures are provided from the respective modules 214, 216 of the simplified calculation model 212 to the life consumption prediction module 220 for predicting S306 the life consumption occurred during the second load session. The predicted life consumption is, again, stored.

Furthermore, in order to determine an accumulated life consumption of the component after the second load session, the predicted S303 life consumption of the component for the second load session is added S307 to the predicted S306 and stored predicted life consumption of the critical point of the component for the first load session. Hereby, an accumulation of predicted life consumption for the critical point of the component is provided.

Moreover, the method steps S301 - S307 is thereafter continuously executed for all of the critical points of the component until a predetermined acceptable life consumption limit of the component has been reach, whereby the component can, for example, be replaced or repaired. The determination of if the component is ok or not may vary depending on the specific application where it is being used. For some applications the component is replaced if an indication of crack initiation has occurred, while for other applications cracks may be allowed within specific criteria of crack propagation. Moreover, for some applications, such as for e.g. aircrafts, the component is replaced even before a crack is initiated.

Furthermore, although the simplified calculation model has been verified in the method step S111 above, the method steps S101 - S111 may be executed within predetermined intervals for the component in order to further increase validation and to confirm the correctness of the model.

Moreover, although the above description has described that the stress/strain modules 208, 214 calculates stresses and strains, the present invention is equally applicable only calculating one of stresses or strains, i.e. the invention should not be construed as limited to calculation of both stresses and strains. Moreover, the stress/strain module, or other subsequent module may, if the stresses/strains from the numerical calculation model are provided as multiple stress/strain components, calculate a principal stress/strain component for comparison to the corresponding stress/strain component provided by the simplified calculation model.

Thus, the above description of the example embodiment of the present invention and the accompanying drawings are to be regarded as a non-limiting example of the invention and the scope of protection is defined by the appended claims. Any reference sign in the claims should not be construed as limiting the scope.

**Claims**

1. A method for generating a simplified calculation model (212) for use in predicting life consumption of a component subjected to loads during operation, comprising the steps of:

   - receiving (S101) a first set of load input data resulting from a first set of load sessions during operation;
   - calculating (S102) at least one of stresses, strains and temperatures for a critical area of said component by means of a numerical calculation model (206);
   - predicting (S103) life consumption of said component based on said at least one of the numerically calculated stresses, strains and temperatures;

   **characterised in that** the method further comprises the step of:

   - generating (S104) said simplified calculation model defining a relationship between load input data and predicted life consumption by means of:
   - assigning a plurality of linear difference equations for said simplified calculation model; and
   - calculating parameters of said plurality of linear difference equations based on said relationship between the first set of load input data and said numerically calculated predicted life consumption.

2. The method according to claim 1, further comprising the steps of:

   - receiving (S105) a second set of load input data resulting from a second set of load sessions during operation;
   - calculating (S106) at least one of stresses, strains and temperatures for said critical area of said component by means of said numerical calculation model;
   - predicting (S109) life consumption of said component based on said at least one of the numerically calculated stresses, strains and temperatures;
   - calculating (S107) at least one of stresses, strains and temperatures for said critical area of said component by means of said simplified calculation model;
   - predicting (S110) life consumption of said component based on said at least one of stresses, strains and temperatures calculated by means of said simplified calculation model; and
   - verifying (S111) that said simplified calculation model is correct if a difference between said numerically calculated predicted life consumption and said predicted life consumption predicted by means of said simplified calculation model is within a predetermined life consumption limit.

3. The method according to claim 2, wherein the step of predicting life consumption of said component based on said at least one of stresses, strains and temperatures calculated by means of said simplified calculation model is preceded by the steps of:

   - comparing (S108) said numerically calculated stresses and/or strains with said stresses and/or strains calculated by means of said simplified calculation model; and
   - predicting life consumption of said component based on said at least one of stresses, strains and temperatures calculated by means of said simplified calculation model if a difference in stresses and/or strains is within a predetermined stress and/or strain limit.

4. The method according to any one of claims 2 or 3, wherein the step of predicting life consumption of said component based on said at least one of stresses, strains and temperatures calculated by means of said simplified calculation model is preceded by the steps of:

   - comparing (S108) said numerically calculated temperatures with said temperatures calculated by means of said simplified calculation model; and
   - predicting life consumption of said component based on said at least one of stresses, strains and temperatures calculated by means of said simplified calculation model if a difference in temperatures is within a predetermined temperature limit.

5. The method according to any one of claims 2 - 4, wherein said simplified calculation model is generated by means of iteratively calculating (S112) said parameters of said linear difference equations until said verification that said simplified calculation model is within said predetermined life consumption limit.

6. The method according to any one of the preceding claims, wherein said linear difference equations comprises the equation:

$$y_i(t) + a_i\_1 \times y_i(t-1) + ... + a_i\_na \times y_i(t-na) = b_i\_1 \times u_i(t-nk) + ... + b_i\_nb \times u_i(t-nk-nb+1)$$

wherein ui(t) are time-dependent inputs resulting from said load sessions during operation, yi(t) are time-dependent stresses, strains or temperatures, na and nb are the number of ai- and bi-parameters, respectively, and nk are the number of sample times before the current time t.

7. The method according to claim 6, wherein said linear difference equations further comprises equations relating the stresses, strains and temperatures with the predicted life consumption.

8. The method according to any one of the preceding claims, wherein said simplified calculation model comprises a temperature calculating module and a stress/strain calculating module.

9. The method according to any one of the preceding claims, wherein said calculated stresses, strains and temperatures are time-dependent components.

10. The method according to any one of the preceding claims, wherein said load sessions are constituted by recorded loads from a flight mission of an aircraft.

11. The method according any one of the preceding claims, wherein said numerical calculation model is a mesh-based numerical model using finite element calculations.

12. The method according to any one of the preceding claims, wherein said load input data comprises at least one of thermal- and mechanical loads.

13. A method for predicting life consumption of a component subjected to loads during operation, comprising the steps of:

   - receiving a first set of load input data resulting from a first load session during operation;
   - calculating at least one of stresses, strains and temperature for a critical area of said component based on said first set of load input data by means of a simplified calculation model
   and
   - predicting life consumption of said component for said first load session based on said at least one of the calculated stresses, strains and temperatures ;

   **characterised in that** said simplified calculation model comprises linear difference equations.

14. The method according to claim 13, wherein said simplified calculation model is generated according to any one of claims 1 - 12;

15. The method according to any one of claims 13 or 14, further comprising the steps of:

   - receiving a second set of load input data resulting from a second load session during operation;
   - calculating at least one of stresses, strains and temperatures for said critical area of said component by means of said simplified calculation model;
   - predicting life consumption of said component for said second load session based on said calculated stresses, strains and temperatures; and
   - adding said predicted life consumption resulting from said second load session with said predicted life consumption resulting from said first load session for accumulation of life consumption of said component.

16. The method according to any one of claims 14 -15, preceded by the steps of:

> - receiving a third set of load input data resulting from a third load session during operation;
> - calculating at least one of stresses, strains and temperatures for said critical area of said component by means of said numerical calculation model and said simplified calculation model;
> - predicting life consumption of said component for said third load session based on said at least one of stresses, strains and temperatures calculated by means of said numerical calculation model and said simplified calculation model; and
> - validating that said simplified calculation model is correct if a difference between said numerically predicted life consumption and said predicted life consumption predicted by means of said simplified calculation model is within a predetermined life consumption limit.

17. The method according to claim 13, wherein said linear difference equations comprises the equation:

$$y_i(t) + a_i\_1 \times y_i(t-1) + ... + a_i\_na \times y_i(t-na) = b_i\_1 \times u_i(t-nk) + ... + b_i\_nb \times u_i(t-nk-nb+1)$$

wherein $u_i(t)$ are time-dependent inputs resulting from said load sessions during operation, $y_i(t)$ are time-dependent stresses, strains or temperatures, na and nb are the number of $a_i$- and $b_i$-parameters, respectively, and nk are the number of sample times before the current time t.

18. The method according to claim 17, wherein said linear difference equations further comprises equations relating the stresses, strains and temperatures with the predicted life consumption.

19. The method according to claim 13, wherein said simplified calculation model comprises a temperature calculating module and a stress/strain calculating module.

20. The method according to claim 13, wherein said calculated stresses, strains and temperatures are time-dependent components.

21. The method according to claim 13, wherein said load session is constituted by recorded loads from a flight mission of an aircraft.

22. The method according to claim 13, wherein said load input data comprises at least one of thermal- and mechanical loads.

23. A system for generating a simplified calculation model, wherein said system comprises:

> - a load session module comprising load session information exposed to a machine during operation;
> - a load input data module comprising load generating means for transformation of load session information to thermal and mechanical loads;
> - a numerical calculation model comprising a temperature calculating module and a stress/strain calculating module;
> - a simplified calculating module comprising a temperature calculating module and a stress/strain calculating module; and
> - a life consumption prediction module comprising means for predicting life consumption based on at least one of stresses, strains and temperatures;

wherein said system is configured to:

> - receive a first set of load input data resulting from a first set of load sessions during operation;
> - calculate at least one of stresses, strains and temperatures for a critical area of a component by means of said numerical calculation model;
> - predict life consumption of said component based on said at least one of the numerically calculated stresses, strains and temperatures by means of said life consumption prediction module; and
> - generate the simplified calculation model defining a relationship between load input data and predicted life consumption for said component by means of;
> - assigning a plurality of linear difference equations for said simplified calculation model; and

- calculating parameters of said plurality of linear difference equations based on said relationship between the first set of load input data and at least one of said numerically calculated predicted life consumption.

24. A system for predicting life consumption of a component subjected to loads during operation, wherein said system comprises:

- a load session module comprising load session information exposed to a machine during operation;
- a load input data module comprising load generating means for transformation of load session information to thermal and mechanical loads;
- a simplified calculation model comprising a temperature calculating module and a stress/strain calculating module; and
- a life consumption prediction module comprising means for predicting life consumption based on at least one of stresses, strains and temperatures;

wherein said system is configured to:

- receive a first set of load input data resulting from a first load session during operation;
- calculate at least one of stresses, strains and temperature for a critical area of a component based on said first load input data and by means of said simplified calculation model comprising linear difference equations; and
- predict life consumption of said component for said first load session based on said at least one of the calculated stresses, strains and temperatures.

25. The system according to claim 24, wherein said simplified calculation model is generated according to claim 23.

26. Computer program product comprising a computer readable medium having stored thereon computer program means for causing a processing unit to generate a simplified calculation model of a component subjected to loads during operation, wherein the computer program product comprises:

- code for executing the method according to any one of claims 1 - 12.

27. Computer program product comprising a computer readable medium having stored thereon computer program means for causing a processing unit to predict life consumption of a component subjected to loads during operation, wherein the computer program product comprises:

- code for executing the method according to any one of claims 13 - 22.

**Patentansprüche**

1. Verfahren zum Erzeugen eines vereinfachten Berechnungsmodells (212) zur Verwendung bei der Vorhersage des Lebensdauerverbrauchs einer Komponente, die während des Betriebs Belastungen ausgesetzt ist, das die folgenden Schritte umfasst:

- Empfangen (S101) eines ersten Satzes von Lasteingabedaten, die aus einem ersten Satz von Belastungssitzungen während des Betriebs resultieren;
- Berechnen (S102) von mindestens einem Element aus Spannungen, Dehnungen und Temperaturen für einen kritischen Bereich der Komponente mittels eines numerischen Berechnungsmodells (206);
- Vorhersagen (S103) des Lebensdauerverbrauchs der Komponente auf der Basis des mindestens einen Elementes aus den numerisch berechneten Spannungen, Dehnungen und Temperaturen;

**dadurch gekennzeichnet, dass** das Verfahren ferner den folgenden Schritt umfasst:

- Erzeugen (S104) des vereinfachten Berechnungsmodells, das eine Beziehung zwischen Lasteingabedaten und vorhergesagtem Lebensdauerverbrauch definiert durch:
- Zuweisen einer Vielzahl von linearen Differenzgleichungen für das vereinfachte Berechnungsmodell; und
- Berechnen von Parametern der Vielzahl von linearen Differenzgleichungen auf der Basis der Beziehung zwischen dem ersten Satz von Lasteingabedaten und dem numerisch berechneten vorhergesagten Lebensdauerverbrauch.

**2.** Verfahren nach Anspruch 1, das ferner die folgenden Schritte umfasst:

- Empfangen (S105) eines zweiten Satzes von Lasteingabedaten, die aus einem zweiten Satz von Belastungssitzungen während des Betriebs resultieren;
- Berechnen (S106) von mindestens einem Element aus Spannungen, Dehnungen und Temperaturen für den kritischen Bereich der Komponente mittels des numerischen Berechnungsmodells;
- Vorhersagen (S109) des Lebensdauerverbrauchs der Komponente auf der Basis von mindestens einem Element aus den numerisch berechneten Spannungen, Dehnungen und Temperaturen;
- Berechnen (S107) von mindestens einem Element aus Spannungen, Dehnungen und Temperatur für den kritischen Bereich der Komponente mittels des vereinfachten Berechnungsmodells;
- Vorhersagen (S110) des Lebensdauerverbrauchs der Komponente, das auf dem mindestens einen Element aus Spannungen, Dehnungen und Temperaturen beruht, die mittels des vereinfachten Berechnungsmodells berechnet werden; und
- Überprüfen (S111), dass das vereinfachte Berechnungsmodell korrekt ist, wenn eine Differenz zwischen dem numerisch berechneten vorhergesagten Lebensdauerverbrauch und dem vorhergesagten Lebensdauerverbrauch, der mittels des vereinfachten Berechnungsmodells vorhergesagt wird, innerhalb eines vorgegebenen Lebensdauerverbrauchs-Grenzwertes liegt.

**3.** Verfahren nach Anspruch 2, wobei dem Schritt des Vorhersagens des Lebensdauerverbrauchs der Komponente auf der Basis des mindestens einen Elementes aus Spannungen, Dehnungen und Temperaturen, das mittels des vereinfachten Berechnungsmodells berechnet wurde, die folgenden Schritte vorausgehen:

- Vergleichen (S108) der numerisch berechneten Spannungen und/oder Dehnungen mit den Spannungen und/oder Dehnungen, die mittels des vereinfachten Berechnungsmodells berechnet wurden; und

Vorhersagen des Lebensdauerverbrauchs der Komponente auf der Basis des mindestens einen Elementes aus Spannungen, Dehnungen und Temperaturen, der durch das vereinfachte Berechnungsmodell berechnet wurde, wenn eine Differenz in den Spannungen und/oder Dehnungen innerhalb eines vorgegebenen Spannungs- und/oder Dehnungsgrenzwertes liegt.

**4.** Im Verfahren nach einem der Ansprüche 2 oder 3, wobei dem Schritt des Vorhersagens des Lebensdauerverbrauchs der Komponente auf der Basis des mindestens einen Elementes aus Spannungen, Dehnungen und Temperaturen, das mittels des vereinfachten Berechnungsmodells berechnet wurde, die folgenden Schritte vorausgehen:

- Vergleichen (S108) der numerisch berechneten Temperaturen mit den Temperaturen, die mittels des vereinfachten Berechnungsmodells berechnet wurden; und
- Vorhersagen des Lebensdauerverbrauchs der Komponente auf der Basis von mindestens einem Element aus Spannungen, Dehnungen und Temperaturen, das mittels des vereinfachten Berechnungsmodells berechnet wurde, wenn eine Differenz in den Temperaturen innerhalb eines vorgegebenen Temperaturgrenzwertes liegt.

**5.** Verfahren nach einem der Ansprüche 2-4, wobei das vereinfachte Berechnungsmodell mittels iterativer Berechnung (S112) der Parameter der linearen Differenzgleichungen erzeugt wird, bis zur Überprüfung, dass das vereinfachte Berechnungsmodell innerhalb des vorgegebenen Lebensdauerverbrauchs-Grenzwertes liegt.

**6.** Verfahren nach einem der vorherigen Ansprüche, wobei die linearen Differenzgleichungen die Gleichung umfassen:

$$y_i(t) + a_i\_1 \times y_i(t-1) + ... + a_i\_na \times y_i(t-na) = b_i\_1 \times u_i(t-nk) + ... + b_i\_nb \times u_i(t-nk-nb+1)$$

wobei die $u_i(t)$ zeitabhängige Eingaben sind, die aus den Belastungssitzungen während des Betriebs resultieren, $y_i(t)$ sind zeitabhängige Spannungen, Dehnungen oder Temperaturen, $na$ und $nb$ sind die Zahl von $a_i$- bzw. $b_i$-Parametern, und $nk$ sind die Zahl von Abtastzeiten vor der aktuellen Zeit $t$.

**7.** Verfahren nach Anspruch 6, wobei die linearen Differenzgleichungen ferner Gleichungen umfassen, die die Spannungen, Dehnungen und Temperaturen mit dem vorhergesagten Lebensdauerverbrauch verknüpfen.

**8.** Verfahren nach einem der vorherigen Ansprüche, wobei das vereinfachte Berechnungsmodell ein Temperaturberechnungsmodul und ein Spannungs-/Dehnungs-Berechnungsmodul umfasst.

**9.** Verfahren nach einem der vorherigen Ansprüche, wobei die berechneten Spannungen, Dehnungen und Temperaturen zeitabhängige Komponenten sind.

**10.** Verfahren nach einem der vorherigen Ansprüche, wobei die Belastungssitzungen aus aufgezeichneten Belastungen von einem Flugeinsatz eines Flugzeugs bestehen.

**11.** Verfahren nach einem der vorherigen Ansprüche, wobei das numerische Berechnungsmodell ein netzbasiertes numerisches Modell ist, das Finite-Elemente-Berechnungen verwendet.

**12.** Verfahren nach einem der vorherigen Ansprüche, wobei die Lasteingabedaten mindestens ein Element aus thermischen und mechanischen Belastungen umfassen.

**13.** Verfahren zum Vorhersagen des Lebensdauerverbrauchs einer Komponente, die Belastungen während des Betriebs ausgesetzt ist, das die folgenden Schritte umfasst:

- Empfangen eines ersten Satzes von Lasteingabedaten, die aus einer ersten Belastungssitzung während des Betriebs resultieren;
- Berechnen von mindestens einem Element aus Spannungen, Dehnungen und Temperatur für einen kritischen Bereich der Komponente, das auf dem ersten Satz von Lasteingabedaten beruht, mittels eines vereinfachten Berechnungsmodells, und
- Vorhersagen des Lebensdauerverbrauchs der Komponente für die erste Belastungssitzung auf der Basis des mindestens einen Elementes aus den berechneten Spannungen, Dehnungen und Temperaturen; **dadurch gekennzeichnet, dass** das vereinfachte Berechnungsmodell lineare Differenzgleichungen enthält.

**14.** Verfahren nach Anspruch 13, wobei das vereinfachte Berechnungsmodell nach einem der Ansprüche 1-12 erzeugt wird.

**15.** Verfahren nach einem der Ansprüche 13 oder 14, das ferner die folgenden Schritte umfasst:

- Empfangen eines zweiten Satzes von Lasteingabedaten, die aus einer zweiten Belastungssitzung während des Betriebs resultieren;
- Berechnen von mindestens einem Element aus Spannungen, Dehnungen und Temperaturen für den kritischen Bereich der Komponente mittels des vereinfachten Berechnungsmodells;
- Vorhersagen des Lebensdauerverbrauchs der Komponente für die zweite Belastungssitzung auf der Basis der berechneten Spannungen, Dehnungen und Temperaturen; und
- Hinzufügen des vorhergesagten Lebensdauerverbrauchs, der aus der zweiten Belastungssitzung resultiert, zum vorhergesagten Lebensdauerverbrauch, der aus der ersten Belastungssitzung resultiert, zur Akkumulation des Lebensdauerverbrauchs der Komponente.

**16.** Verfahren nach einem der Ansprüche 14-15, dem die folgenden Schritte vorausgehen:

- Empfangen eines dritten Satzes von Lasteingabedaten, die aus einer dritten Belastungssitzung während des Betriebs resultieren;
- Berechnen von mindestens einem Element aus Spannungen, Dehnungen und Temperaturen für den kritischen Bereich der Komponente mittels des numerischen Berechnungsmodells und des vereinfachten Berechnungsmodells;
- Vorhersagen des Lebensdauerverbrauchs der Komponente für die dritte Belastungssitzung auf der Basis des mindestens einen Elementes von Spannungen, Dehnungen und Temperaturen, berechnet mittels des numerischen Berechnungsmodells und des vereinfachten Berechnungsmodells; und
- Bestätigen, dass das vereinfachte Berechnungsmodell korrekt ist, wenn eine Differenz zwischen dem numerisch vorhergesagten Lebensdauerverbrauch und dem vorhergesagten Lebensdauerverbrauch, der mittels des vereinfachten Berechnungsmodells vorhergesagt wurde, innerhalb eines vorgegebenen Lebensdauerverbrauchs-Grenzwertes liegt.

**17.** Verfahren nach Anspruch 13, wobei die linearen Differenzgleichungen die folgende Gleichung umfassen:

$$y_i(t) + a_i\_1 \times y_i(t-1) + ... + a_i\_na \times y_i(t-na) = b_i\_1 \times u_i(t-nk) + ... + b_i\_nb \times u_i(t-nk-nb+1)$$

wobei die $u_i(t)$ zeitabhängige Eingaben sind, die aus den Belastungssitzungen während des Betriebs resultieren, $Y_i(t)$ sind zeitabhängige Spannungen, Dehnungen oder Temperaturen, *na* und *nb* sind die Zahl von $a_i$- bzw. $b_i$-Parametern, und *nk* sind die Zahl von Abtastzeiten vor der aktuellen Zeit *t*.

18. Verfahren nach Anspruch 17, wobei die linearen Differenzgleichungen ferner Gleichungen umfassen, die die Spannungen, Dehnungen und Temperaturen mit dem vorhergesagten Lebensdauerverbrauch verknüpfen.

19. Verfahren nach Anspruch 13, wobei das vereinfachte Berechnungsmodell ein Temperaturberechnungsmodul und ein Spannungs-/Dehnungs-Berechnungsmodul umfasst.

20. Verfahren nach Anspruch 13, wobei die berechneten Spannungen, Dehnungen und Temperaturen zeitabhängige Komponenten sind.

21. Verfahren nach Anspruch 13, wobei die Belastungssitzung durch die aufgezeichneten Belastungen aus einem Flugeinsatz eines Flugzeugs besteht.

22. Verfahren nach Anspruch 13, wobei die Lasteingabedaten mindestens eine Belastung aus thermischen und mechanischen Belastungen umfassen.

23. System zum Erzeugen eines vereinfachten Berechnungsmodells, wobei das System umfasst:

- ein Belastungssitzungsmodul, das Belastungssitzungsinformationen umfasst, der eine Maschine während des Betriebs ausgesetzt ist;
- ein Lasteingabedaten-Modul, das Lasterzeugungsmittel zum Transformieren von Lastsitzungsinformationen in thermische und mechanische Lasten umfasst;
- ein numerisches Berechnungsmodell, das ein Temperaturberechnungsmodul und ein Spannungs-/Dehnungsberechnungsmodul umfasst;
- ein vereinfachtes Berechnungsmodul, das ein Temperaturberechnungsmodul und ein Spannungs-/Dehnungsberechnungsmodul umfasst; und
- ein Lebensdauerverbrauchs-Vorhersagemodul, das Mittel zum Vorhersagen des Lebensdauerverbrauchs auf der Basis von mindestens einem Element aus Spannungen, Dehnungen und Temperaturen umfasst;

wobei das System für Folgendes ausgelegt ist:

- Empfangen eines ersten Satzes von Lasteingabedaten, die aus einem ersten Satz von Belastungssitzungen während des Betriebs resultieren;
- Berechnen von mindestens einem Element aus Spannungen, Dehnungen und Temperaturen für einen kritischen Bereich einer Komponente mittels des numerischen Berechnungsmodells;
- Vorhersagen des Lebensdauerverbrauchs der Komponente auf der Basis des mindestens einen Elementes aus den numerisch berechneten Spannungen, Dehnungen und Temperaturen mittels des Lebensdauerverbrauchs-Vorhersagemoduls; und
- Erzeugen des vereinfachten Berechnungsmodells, das eine Beziehung zwischen Lasteingabedaten und vorhergesagtem Lebensdauerverbrauch für die Komponente definiert unter Verwendung von:
- Zuweisen einer Vielzahl von linearen Differenzgleichungen für das vereinfachte Berechnungsmodell; und
- Berechnung von Parametern aus der Vielzahl von linearen Differenzgleichungen auf der Basis der Beziehung zwischen dem ersten Satz von Lasteingabedaten und von mindestens einem Element aus dem numerisch berechneten vorhergesagten Lebensdauerverbrauch.

24. System zum Vorhersagen von Lebensdauerverbrauch einer Komponente, die während des Betriebs Belastungen ausgesetzt ist, wobei das System umfasst:

- ein Belastungssitzungsmodul, das Belastungssitzungsinformationen umfasst, der eine Maschine während des Betriebs ausgesetzt ist;
- ein Lasteingabedaten-Modul, das Lasterzeugungsmittel zum Transformieren von Lastsitzungsinformationen in thermische und mechanische Lasten umfasst;

- ein vereinfachtes Berechnungsmodell, das ein Temperaturberechnungsmodul und ein Spannungs-/Dehnungsberechnungsmodul umfasst; und
- ein Lebensdauerverbrauchs-Vorhersagemodul, das Mittel zum Vorhersagen des Lebensdauerverbrauchs auf der Basis von mindestens einem Element aus Spannungen, Dehnungen und Temperaturen umfasst;

wobei das System für Folgendes ausgelegt ist:

- Empfangen eines ersten Satzes von Lasteingabedaten, die aus einer ersten Belastungssitzung während des Betriebs resultieren;
- Berechnen von mindestens einem Element aus Spannungen, Dehnungen und Temperatur für einen kritischen Bereich einer Komponente auf der Basis der ersten Lasteingabedaten und mittels des vereinfachten Berechnungsmodells, das lineare Differenzgleichungen enthält; und
- Vorhersage des Lebensdauerverbrauchs der Komponente für die erste Belastungssitzung auf der Basis des mindestens einen Elementes aus den berechneten Spannungen, Dehnungen und Temperaturen.

25. System nach Anspruch 24, wobei das vereinfachte Berechnungsmodell nach Anspruch 23 erzeugt wird.

26. Computerprogrammprodukt, das ein computerlesbares Medium umfasst, welches darauf gespeichert Programmmittel hat, um eine Verarbeitungseinheit zu veranlassen, ein vereinfachtes Berechnungsmodell einer Komponente zu erzeugen, die Belastungen während des Betriebs ausgesetzt ist, wobei das Computerprogramm-Produkt umfasst:

- Code zum Ausführen des Verfahrens nach einem der Ansprüche 1-12.

27. Computerprogramm-Produkt, das ein computerlesbares Medium umfasst, welches darauf gespeichert Computerprogramm-Mittel hat, um eine Verarbeitungseinheit zu veranlassen, den Lebensdauerverbrauch einer Komponente vorherzusagen, die Belastungen während des Betriebs ausgesetzt ist, wobei das Computerprogramm-Produkt umfasst:

- Code zum Ausführen des Verfahrens nach einem der Ansprüche 13-22.

**Revendications**

1. Procédé pour générer un modèle de calcul simplifié (212) destiné à être utilisé pour prédire l'utilisation de la durée de vie d'un composant soumis à des charges durant le fonctionnement, comprenant les étapes consistant à :

- recevoir (S101) un premier ensemble de données d'entrée de charge résultant d'un premier ensemble de sessions de charge ayant lieu durant le fonctionnement ;
- calculer (S102) au moins un élément d'information parmi des contraintes, des déformations et des températures concernant une région critique dudit composant au moyen d'un modèle de calcul numérique (206) ;
- prédire (S103) l'utilisation de la durée de vie dudit composant d'après ledit au moins un élément d'information parmi des contraintes, des déformations et des températures calculées numériquement ;

le procédé étant **caractérisé en ce qu'**il comprend également l'étape consistant à :

- générer (S104) ledit modèle de calcul simplifié en définissant une relation entre les données d'entrée de charge et l'utilisation de la durée de vie prédite en :
- attribuant une pluralité d'équations linéaires aux différences finies pour ledit modèle de calcul simplifié ; et en
- calculant des paramètres de ladite pluralité d'équations linéaires aux différences finies d'après ladite relation entre le premier ensemble de données d'entrée de charge et ladite utilisation de la durée de vie prédite qui a été calculée numériquement.

2. Procédé selon la revendication 1, comprenant également les étapes consistant à :

- recevoir (S105) un deuxième ensemble de données d'entrée de charge résultant d'un deuxième ensemble de sessions de charge ayant lieu durant le fonctionnement ;
- calculer (S106) au moins un élément d'information parmi des contraintes, des déformations et des températures concernant ladite région critique dudit composant au moyen dudit modèle de calcul numérique ;

- prédire (S109) l'utilisation de la durée de vie dudit composant d'après ledit au moins un élément d'information parmi des contraintes, des déformations et des températures calculées numériquement ;
- calculer (S107) au moins un élément d'information parmi des contraintes, des déformations et des températures concernant ladite région critique dudit composant au moyen dudit modèle de calcul simplifié ;
- prédire (S110) l'utilisation de la durée de vie dudit composant d'après ledit au moins un élément d'information parmi des contraintes, des déformations et des températures calculées au moyen dudit modèle de calcul simplifié ; et
- vérifier (S111) que ledit modèle de calcul simplifié est correct si une différence entre ladite utilisation de la durée de vie prédite qui a été calculée numériquement et ladite utilisation de la durée de vie prédite qui a été prédite au moyen dudit modèle de calcul simplifié se trouve dans une limite prédéterminée d'utilisation de la durée de vie.

3. Procédé selon la revendication 2, dans lequel l'étape consistant à prédire l'utilisation de la durée de vie dudit composant d'après ledit au moins un élément d'information parmi des contraintes, des déformations et des températures calculées au moyen dudit modèle de calcul simplifié est précédée des étapes consistant à :

- comparer (S108) lesdites contraintes et/ou déformations calculées numériquement auxdites contraintes et/ou déformations calculées au moyen dudit modèle de calcul simplifié ; et
- prédire l'utilisation de la durée de vie dudit composant d'après ledit au moins un élément d'information parmi des contraintes, des déformations et des températures calculées au moyen dudit modèle de calcul simplifié si une différence dans les contraintes et/ou les déformations se trouve dans une limite prédéterminée de contrainte et/ou de déformation.

4. Procédé selon l'une quelconque des revendications 2 et 3, dans lequel l'étape consistant à prédire l'utilisation de la durée de vie dudit composant d'après ledit au moins un élément d'information parmi des contraintes, des déformations et des températures calculées au moyen dudit modèle de calcul simplifié est précédée des étapes consistant à :

- comparer (S108) lesdites températures calculées numériquement auxdites températures calculées au moyen dudit modèle de calcul simplifié ; et
- prédire l'utilisation de la durée de vie dudit composant d'après ledit au moins un élément d'information parmi des contraintes, des déformations et des températures calculées au moyen dudit modèle de calcul simplifié si une différence dans les températures se trouve dans une limite de température prédéterminée.

5. Procédé selon l'une quelconque des revendications 2 à 4, dans lequel ledit modèle de calcul simplifié est généré au moyen d'un calcul itératif (S112) desdits paramètres desdites équations linéaires aux différences finies jusqu'à ladite vérification du fait que ledit modèle de calcul simplifié se trouve dans ladite limite prédéterminée d'utilisation de la durée de vie.

6. Procédé selon l'une quelconque des revendications précédentes, dans lequel lesdites équations linéaires aux différences finies comprennent l'équation :

$$y_i(t) + a_i\_1 \times y_i(t-1) + \ldots + a_i\_na \times y_i(t-na) = b_i\_1 \times u_i(t-nk) + \ldots + b_i\_nb \times u_i(t-nk-nb+1)$$

dans laquelle les $u_i(t)$ sont des entrées dépendantes du temps résultant desdites sessions de charge ayant lieu durant le fonctionnement, les $y_i(t)$ sont des contraintes, des déformations ou des températures dépendantes du temps, na et nb sont le nombre de paramètres $a_i$- et $b_i$-, respectivement, et nk est le nombre de fois où il y a eu un échantillonnage avant l'instant actuel t.

7. Procédé selon la revendication 6, dans lequel lesdites équations linéaires aux différences finies comprennent également des équations qui relient les contraintes, les déformations et les températures à l'utilisation de la durée de vie prédite.

8. Procédé selon l'une quelconque des revendications précédentes, dans lequel ledit modèle de calcul simplifié comprend un module de calcul de température et un module de calcul de contrainte/déformation.

9. Procédé selon l'une quelconque des revendications précédentes, dans lequel lesdites contraintes, déformations et températures calculées sont des composantes dépendantes du temps.

10. Procédé selon l'une quelconque des revendications précédentes, dans lequel lesdites sessions de charge sont constituées par des charges enregistrées au cours d'une mission de vol d'un aéronef.

11. Procédé selon l'une quelconque des revendications précédentes, dans lequel ledit modèle de calcul numérique est un modèle numérique à base de mailles utilisant des calculs par la méthode des éléments finis.

12. Procédé selon l'une quelconque des revendications précédentes, dans lequel lesdites données d'entrée de charge contiennent au moins un élément d'information parmi des charges thermiques et des charges mécaniques.

13. Procédé pour prédire l'utilisation de la durée de vie d'un composant soumis à des charges durant le fonctionnement, comprenant les étapes consistant à :

    - recevoir un premier ensemble de données d'entrée de charge résultant d'une première session de charge ayant lieu durant le fonctionnement ;
    - calculer au moins un élément d'information parmi des contraintes, des déformations et une température concernant une région critique dudit composant à partir dudit premier ensemble de données d'entrée de charge au moyen d'un modèle de calcul simplifié
    et
    - prédire l'utilisation de la durée de vie dudit composant pour ladite première session de charge d'après ledit au moins un élément d'information parmi des contraintes, des déformations et des températures calculées ;

    **caractérisé en ce que** ledit modèle de calcul simplifié comprend des équations linéaires aux différences finies.

14. Procédé selon la revendication 13, dans lequel ledit modèle de calcul simplifié est généré selon l'une quelconque des revendications 1 à 12.

15. Procédé selon l'une quelconque des revendications 13 et 14, comprenant également les étapes consistant à :

    - recevoir un deuxième ensemble de données d'entrée de charge résultant d'une deuxième session de charge ayant lieu durant le fonctionnement ;
    - calculer au moins un élément d'information parmi des contraintes, des déformations et des températures concernant ladite région critique dudit composant au moyen dudit modèle de calcul simplifié ;
    - prédire l'utilisation de la durée de vie dudit composant pour ladite deuxième session de charge d'après lesdites contraintes, déformations et températures calculées ; et
    - ajouter ladite utilisation de la durée de vie prédite résultant de ladite deuxième session de charge à ladite utilisation de la durée de vie prédite résultant de ladite première session de charge pour accumuler l'utilisation de la durée de vie dudit composant.

16. Procédé selon l'une quelconque des revendications 14 et 15, précédé des étapes consistant à :

    - recevoir un troisième ensemble de données d'entrée de charge résultant d'une troisième session de charge ayant lieu durant le fonctionnement ;
    - calculer au moins un élément d'information parmi des contraintes, des déformations et des températures concernant ladite région critique dudit composant au moyen dudit modèle de calcul numérique et dudit modèle de calcul simplifié ;
    - prédire l'utilisation de la durée de vie dudit composant pour ladite troisième session de charge d'après ledit au moins un élément d'information parmi des contraintes, des déformations et des températures calculées au moyen dudit modèle de calcul numérique et dudit modèle de calcul simplifié ; et
    - confirmer le fait que ledit modèle de calcul simplifié est correct si une différence entre ladite utilisation de la durée de vie prédite numériquement et ladite utilisation de la durée de vie prédite qui a été prédite au moyen dudit modèle de calcul simplifié se trouve dans une limite prédéterminée d'utilisation de la durée de vie.

17. Procédé selon la revendication 13, dans lequel lesdites équations linéaires aux différences finies comprennent l'équation :

$$y_i(t)+a_i\_1\times y_i(t-1)+...+a_i\_na\times y_i(t-na)=b_i\_1\times u_i(t-nk)+...+b_i\_nb\times u_i(t-nk-nb+1)$$

dans laquelle les ui(t) sont des entrées dépendantes du temps résultant desdites sessions de charge ayant lieu durant le fonctionnement, les yi(t) sont des contraintes, des déformations ou des températures dépendantes du temps, na et nb sont le nombre de paramètres ai- et bi-, respectivement, et nk est le nombre de fois où il y a eu un échantillonnage avant l'instant actuel t.

18. Procédé selon la revendication 17, dans lequel lesdites équations linéaires aux différences finies comprennent également des équations qui relient les contraintes, les déformations et les températures à l'utilisation de la durée de vie prédite.

19. Procédé selon la revendication 13, dans lequel ledit modèle de calcul simplifié comprend un module de calcul de température et un module de calcul de contrainte/déformation.

20. Procédé selon la revendication 13, dans lequel lesdites contraintes, déformations et températures calculées sont des composantes dépendantes du temps.

21. Procédé selon la revendication 13, dans lequel ladite session de charge est constituée par des charges enregistrées au cours d'une mission de vol d'un aéronef.

22. Procédé selon la revendication 13, dans lequel lesdites données d'entrée de charge contiennent au moins un élément d'information parmi des charges thermiques et des charges mécaniques.

23. Système pour générer un modèle de calcul simplifié, ledit système comprenant :

- un module de session de charge comprenant des informations de session de charge auxquelles une machine est exposée durant le fonctionnement ;
- un module de données d'entrée de charge comprenant un moyen de génération de charge servant à transformer les informations de session de charge en charges thermiques et mécaniques ;
- un modèle de calcul numérique comprenant un module de calcul de température et un module de calcul de contrainte/déformation ;
- un modèle de calcul simplifié comprenant un module de calcul de température et un module de calcul de contrainte/déformation ; et
- un module de prédiction de l'utilisation de la durée de vie comprenant un moyen pour prédire l'utilisation de la durée de vie d'après au moins un élément d'information parmi des contraintes, des déformations et des températures ;

ledit système étant configuré pour :

- recevoir un premier ensemble de données d'entrée de charge résultant d'un premier ensemble de sessions de charge ayant lieu durant le fonctionnement ;
- calculer au moins un élément d'information parmi des contraintes, des déformations et des températures concernant une région critique d'un composant au moyen dudit modèle de calcul numérique ;
- prédire l'utilisation de la durée de vie dudit composant d'après ledit au moins un élément d'information parmi des contraintes, des déformations et des températures calculées numériquement au moyen dudit module de prédiction de l'utilisation de la durée de vie ; et
- générer le modèle de calcul simplifié en définissant une relation entre les données d'entrée de charge et l'utilisation de la durée de vie prédite concernant ledit composant en :
- attribuant une pluralité d'équations linéaires aux différences finies pour ledit modèle de calcul simplifié ; et en
- calculant des paramètres de ladite pluralité d'équations linéaires aux différences finies d'après ladite relation entre le premier ensemble de données d'entrée de charge et au moins une de ladite utilisation de la durée de vie prédite qui a été calculée numériquement.

24. Système pour prédire l'utilisation de la durée de vie d'un composant soumis à des charges durant le fonctionnement, ledit système comprenant :

- un module de session de charge comprenant des informations de session de charge auxquelles une machine est exposée durant le fonctionnement ;
- un module de données d'entrée de charge comprenant un moyen de génération de charge servant à transformer les informations de session de charge en charges thermiques et mécaniques ;
- un modèle de calcul simplifié comprenant un module de calcul de température et un module de calcul de contrainte/déformation ; et
- un module de prédiction de l'utilisation de la durée de vie comprenant un moyen pour prédire l'utilisation de la durée de vie d'après au moins un élément d'information parmi des contraintes, des déformations et des températures ;

ledit système étant configuré pour :

- recevoir un premier ensemble de données d'entrée de charge résultant d'une première session de charge ayant lieu durant le fonctionnement ;
- calculer au moins un élément d'information parmi des contraintes, des déformations et des températures concernant une région critique d'un composant à partir desdites premières données d'entrée de charge et au moyen dudit modèle de calcul simplifié comprenant des équations linéaires aux différences finies ; et
- prédire l'utilisation de la durée de vie dudit composant pour ladite première session de charge d'après ledit au moins un élément d'information parmi des contraintes, des déformations et des températures.

25. Système selon la revendication 24, dans lequel ledit modèle de calcul simplifié est généré selon la revendication 23.

26. Produit de programme d'ordinateur comprenant un support lisible par ordinateur sur lequel est stocké un moyen à base de programme d'ordinateur amenant une unité de traitement à générer un modèle de calcul simplifié d'un composant soumis à des charges durant le fonctionnement, le produit de programme d'ordinateur contenant :

- un code servant à exécuter le procédé selon l'une quelconque des revendications 1 à 12.

27. Produit de programme d'ordinateur comprenant un support lisible par ordinateur sur lequel est stocké un moyen à base de programme d'ordinateur amenant une unité de traitement à prédire l'utilisation de la durée de vie d'un composant soumis à des charges durant le fonctionnement, le produit de programme d'ordinateur contenant :

- un code servant à exécuter le procédé selon l'une quelconque des revendications 13 à 22.

S101 — Receive input

S102 — Calculate

S103 — Predict life consumption

S104 — Generate model ← Re-calculate parameters — S112

S105 — Receive new load input

S106 — Calculate    S108    S107 — Calculate

Compare: within predetermined limits? → No →

S109 — Yes — S110

Predict life consumption    S111    Predict life consumption

Compare: within predetermined limits? → No →

Yes

Model OK

*Fig. 1*

*Fig. 2*

S301 ——— | Provide load input data |

S302 ——— | Calculate |

S303 ——— | Predict |

S304 ——— | Provide |

S305 ——— | Calculate |

S306 ——— | Predict |

S307 ——— | Add |

*Fig. 3*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2011137575 A1

- EP 2045673 A2

**Non-patent literature cited in the description**

- **PFOERTNER H.** The information content of turbine engine data - a chance for recording based life usage monitoring. *IEEE,* 09 March 2002, vol. 6, 2975-2985